(19) **Europäisches Patentamt / European Patent Office / Office européen des brevets**

(11) **EP 3 363 707 B1**

(12) **FASCICULE DE BREVET EUROPEEN**

(45) Date de publication et mention
de la délivrance du brevet:
**20.04.2022 Bulletin 2022/16**

(21) Numéro de dépôt: **18305051.7**

(22) Date de dépôt: **22.01.2018**

(51) Classification Internationale des Brevets (IPC):
**B60W 50/14** (2020.01)   **G01C 21/34** (2006.01)

(52) Classification Coopérative des Brevets (CPC):
**B60W 50/14; G01C 21/3469;** B60K 2370/169;
B60W 2510/24; B60W 2520/10; B60W 2520/14;
B60W 2552/00; B60W 2556/50; B60W 2556/65;
G01C 21/3492; Y02T 10/84

(54) **PROCEDE DE DETERMINATION D'UNE ZONE ATTEIGNABLE PAR UN VEHICULE AU MOYEN D'UN MODELE DYNAMIQUE ET D'UN GRAPHE ADJOINT**

VERFAHREN ZUR BESTIMMUNG EINER MIT EINEM FAHRZEUG ERREICHBAREN ZONE MIT HILFE EINES DYNAMISCHEN MODELLS UND EINES KANTENGRAPHEN

METHOD FOR DETERMINING AN AREA REACHABLE BY A VEHICLE USING A DYNAMIC MODEL AND AN ASSOCIATED GRAPH

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.02.2017 FR 1751262**

(43) Date de publication de la demande:
**22.08.2018 Bulletin 2018/34**

(73) Titulaire: **IFP Energies nouvelles
92852 Rueil-Malmaison Cedex (FR)**

(72) Inventeurs:
• **DE NUNZIO, Giovanni
69600 Oullins (FR)**
• **THIBAULT, Laurent
69001 Lyon (FR)**

(74) Mandataire: **IFP Energies nouvelles
Département Propriété Industrielle
Rond Point de l'échangeur de Solaize
BP3
69360 Solaize (FR)**

(56) Documents cités:
EP-A2- 2 669 632    WO-A1-2014/001565
WO-A2-02/21078    DE-A1-102012 023 632
US-A1- 2013 096 818

• RAMI ABOUSLEIMAN ET AL: "A Bellman-Ford approach to energy efficient routing of electric vehicles", 2015 IEEE TRANSPORTATION ELECTRIFICATION CONFERENCE AND EXPO (ITEC), 1 juin 2015 (2015-06-01), pages 1-4, XP055386219, DOI: 10.1109/ITEC.2015.7165772 ISBN: 978-1-4673-6741-7

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

La présente invention concerne le domaine de la navigation des véhicules, et en particulier le domaine de la prédiction du rayon d'action d'un véhicule, qui correspond à la définition des positions atteignables par le véhicule en fonction de l'énergie stockée restante au sein du véhicule.

Selon l'Agence Internationale de l'Energie, plus du 50% du pétrole utilisé dans le monde est destiné au secteur des transports, dont plus des trois quarts pour les transports routiers. Selon cette même agence, le secteur des transports est responsable pour presque un quart (23.8%) des émissions de gaz à effet de serre et plus d'un quart (27.9%) des émissions de $CO_2$ en Europe en 2006.

Il est donc de plus en plus important d'augmenter l'efficacité énergétique des déplacements routiers, pour réduire la consommation d'énergie, qu'il s'agisse d'énergies fossile ou électrique. Pour y parvenir les systèmes d'assistance à la conduite (ADAS, de l'anglais « Advanced Driver Assistance Systems ») représentent une solution prometteuse, car économique (car on peut utiliser simplement le téléphone intelligent du conducteur) et non intrusive (car on n'a pas besoin d'apporter des modifications aux composants mécaniques du véhicule).

En outre, l'augmentation de l'autonomie des véhicules électriques représente un enjeu majeur pour leur développement. En effet, les faibles capacités de stockage des batteries et les temps de recharges élevés rendent complexes l'utilisation des véhicules électriques et freinent leur diffusion. Par ailleurs, ces problèmes ont tendance à limiter encore plus l'usage des véhicules électriques, car, souvent, l'autonomie restante en kilomètres de route effectivement affichée pour l'utilisateur n'est pas fiable. Par conséquent, les véhicules électriques ayant une faible autonomie restante sont souvent sous-utilisés.

La demande de brevet US 2015/127204 A1 concerne un dispositif de prédiction du rayon d'action d'un véhicule. Toutefois, le dispositif décrit dans ce document ne décrit pas le mode de calcul de l'autonomie du véhicule. Il n'est donc pas garanti que le dispositif présenté dans ce document présente le rayon d'action du véhicule de manière fiable et précise.

La demande de brevet US 2016/129803 A1 concerne une méthode de prédiction du rayon d'action d'un véhicule. Toutefois, la méthode décrite dans ce document ne prend pas en compte l'impact de la route et de l'infrastructure sur la dépense énergétique. Le rayon d'action obtenu par la méthode décrite dans ce document n'est donc pas fiable et précis.

La demande de brevet US 2014/0278038 A1 concerne un procédé de calcul du rayon énergétique au moyen d'une approche de modélisation de la dépense énergétique, et par la prise en compte des manœuvres et de l'impact de l'infrastructure. Toutefois, cette méthode nécessite une mémoire importante pour réaliser le calcul. En effet, ce document propose une solution de sauvegarde des données cartographiques sous forme de liste d'adjacence, qui nécessite une mémoire importante. De plus, la méthode décrite dans cette demande de brevet US 2014/0278038 A1 surestime l'énergie durant les phases d'accélération en supposant que la puissance du moteur atteint sa valeur maximale. En outre, la méthode décrite dans ce document ne donne pas une précision élevée. En effet, cette méthode fait l'hypothèse d'une pente constante sur un arc, qui est une hypothèse simplificatrice qui diminue la précision. De plus, cette méthode utilise une approche macroscopique basée sur la variation d'énergie cinétique avec l'hypothèse d'une efficacité forfaitaire.

La demande de brevet WO 2014/001565 décrit un procédé pour déterminer une zone atteignable par un véhicule basé sur un graphe direct du réseau routier.

Pour pallier ces inconvénients, la présente invention concerne un procédé de détermination d'au moins une zone (un rayon d'action) d'un réseau routier atteignable par un véhicule circulant au sein du réseau routier. Le procédé est basé sur l'utilisation d'un modèle dynamique du véhicule dépendant de la vitesse et de l'accélération du véhicule, la construction d'un graphe adjoint, et un algorithme de plus court chemin. L'utilisation d'un tel modèle dynamique et la construction d'un graphe adjoint permettent une meilleure précision de l'énergie consommée, notamment en prenant en compte les accélérations, ce qui permet de déterminer le rayon d'action de manière précis. En outre, l'utilisation d'un graphe adjoint permet de réduire significativement la mémoire nécessaire pour réaliser la détermination de la zone. Ainsi, le procédé selon l'invention permet une gestion plus efficace de l'énergie, notamment une gestion plus efficace de la batterie d'un véhicule électrique.

**Le procédé selon l'invention**

L'invention concerne un procédé de détermination d'au moins une zone d'un réseau routier atteignable par un véhicule circulant au sein dudit réseau routier selon la revendication 1.

Selon un mode de réalisation, on détermine ladite vitesse moyenne et ladite accélération dudit véhicule au moyen de conditions de trafic et/ou de la topologie et/ou des infrastructures dudit réseau routier.

Avantageusement, on détermine la vitesse moyenne et l'accélération du véhicule au moyen de conditions de trafic, lesdites conditions de trafic sont obtenues en temps réel par communication avec des services de données en ligne.

Alternativement, on détermine la vitesse moyenne et l'accélération du véhicule au moyen de conditions de trafic, lesdites conditions de trafic sont stockées dans des moyens de stockage de données historiques.

Conformément à une mise en œuvre, on détermine la vitesse moyenne et l'accélération du véhicule au moyen de conditions de la topologie, et construit ledit graphe adjoint au moyen de la topologie dudit réseau routier.

De manière avantageuse, on détermine la vitesse moyenne et l'accélération du véhicule au moyen de conditions de la topologie, et détermine ladite topologie dudit réseau routier par des moyens de géolocalisation.

Selon une option de réalisation, ledit modèle dynamique du véhicule dépend de paramètres intrinsèques dudit véhicule.

De préférence, lesdits paramètres intrinsèques dudit véhicule sont obtenus depuis une base de données, ou sont indiqués par un utilisateur.

Conformément à un mode de réalisation, on affiche ladite zone sur un dispositif autonome ou sur le tableau de bord dudit véhicule.

Selon une caractéristique, ledit modèle dynamique dudit véhicule dépend de la demande de puissance d'au moins un système auxiliaire dudit véhicule.

Avantageusement, ladite demande de puissance d'au moins un système auxiliaire est fonction de la température extérieure.

De manière avantageuse, ledit algorithme de chemin le plus court est un algorithme de Bellman-Ford.

Selon une mise en œuvre, on détermine la consommation dudit véhicule pour au moins un point de ladite zone.

Selon une caractéristique, ledit véhicule est un véhicule électrique, et la quantité d'énergie stockée dans le véhicule correspond à l'état de charge de la batterie dudit véhicule.

En outre, l'invention concerne un produit programme d'ordinateur téléchargeable depuis un réseau de communication et/ou enregistré sur un support lisible par ordinateur et/ou exécutable par un processeur ou un serveur, comprenant des instructions de code de programme pour la mise en œuvre du procédé selon l'une des caractéristiques précédentes, lorsque ledit programme est exécuté sur un ordinateur ou sur un téléphone portable.

**Présentation succincte des figures**

D'autres caractéristiques et avantages du procédé selon l'invention, apparaîtront à la lecture de la description ci-après d'exemples non limitatifs de réalisations, en se référant aux figures annexées et décrites ci-après.

La figure 1 illustre les étapes du procédé selon un premier mode de réalisation de l'invention.
La figure 2 illustre les étapes du procédé selon un deuxième mode de réalisation de l'invention.
La figure 3 illustre la construction d'un graphe adjoint selon un mode de réalisation de l'invention.
La figure 4 est une courbe illustrant la demande de puissance d'un système auxiliaire en fonction de la température extérieur.
La figure 5 est un premier exemple de carte obtenue par le procédé selon un mode de réalisation de l'invention et par un procédé selon l'art antérieur.
La figure 6 est un deuxième exemple de carte obtenue par le procédé selon un mode de réalisation de l'invention.
La figure 7 est un troisième exemple de carte obtenue par le procédé selon un mode de réalisation de l'invention, respectivement pour un trajet aller seul, et pour un trajet aller-retour.
Les figures 8a et 8b illustrent deux exemples de réseau routier.

**Description détaillée de l'invention**

La présente invention concerne un procédé de prédiction d'au moins une zone d'un réseau routier par un véhicule circulant au sein du réseau routier. En d'autres termes, le procédé selon l'invention permet de déterminer le rayon d'action d'un véhicule.

Le procédé selon l'invention est adapté à tout type de véhicule : véhicules thermiques, véhicules hybrides, véhicules électriques, etc.

Notations

Dans la suite de la description, on utilise les notations suivantes :

| | | |
|---|---|---|
| $v$ | Vitesse du véhicule | [m/s] |
| $x$ | Position du véhicule | [m] |
| $m$ | Masse du véhicule | [kg] |
| $\omega$ | Régime du moteur du véhicule | [tr/s] |
| $F_W$ | Effort de traction du véhicule à la roue | [N] |
| $F_{areo}$ | Effort aérodynamique sur le véhicule | [N] |

(suite)

| | | | |
|---|---|---|---|
| $F_{friction}$ | Effort de frottement subis par le véhicule | [N] |
| $F_{slope}$ | Effort normal subi par le véhicule (gravité) | [N] |
| $F_{res}$ | Résultante des pertes aérodynamique et de roulement | [N] |
| $\alpha$ | Angle d'inclinaison de la route | [rad] |
| $\rho_a$ | Densité de l'air | [kg/m³] |
| $A_f$ | Surface frontale du véhicule | [m2] |

| | | | |
|---|---|---|---|
| $c_d$ | Coefficient de résistance aérodynamique | [-] |
| $c_r$ | Coefficient de résistance au roulement | [-] |
| $g$ | Accélération gravitationnelle | [m²/s] |
| $a_0$, $a_1$ et $a_2$ | Paramètres du véhicule | [-] |
| $r$ | Rayon de la roue | [m] |
| $\rho_t$ | Rapport de la transmission du véhicule | [-] |
| $\eta_t$ | Rendement de la transmission du véhicule | [-] |
| $T_m$ | Couple moteur | [Nm] |
| $T_{m,max}$ | Couple moteur maximal | [Nm] |
| $T_{m,min}$ | Couple moteur minimal | [Nm] |
| $P_m$ | Puissance disponible sur l'arbre moteur | [W] |
| $P_b$ | Puissance demandée à la batterie | [W] |
| $\eta_b$ | Rendement agrégé de la chaîne de traction électrique | [-] |
| $P_{aux}$ | Puissance des auxiliaires du véhicule | [W] |
| $T_{amb}$ | Température ambiante | [K] |
| $i$ | Segment de route i | [-] |
| $i - 1$ | Segment de route, précédent le segment de route i | [-] |
| $\bar{v}$ | Vitesse moyenne du trafic | [m/s] |
| $K$ | Fonction | |
| $\bar{E}_i$ | Energie consommée sur le segment i | [Wh] |
| $E_b$ | Energie consommée à la batterie | [Wh] |
| $\bar{P}_i$ | Puissance du véhicule sur le segment i à la vitesse moyenne | [W] |
| $\tilde{P}_i$ | Puissance du véhicule sur le segment i à vitesse variable | [W] |
| $T_i$ | Temps de parcours sur le segment i | [s] |
| $l_i$ | Longueur du segment i | [m] |
| $E_{jump,i}$ | Energie consommée associée à la variation de vitesse pour le segment i | [Wh] |
| $t_{jump,i}$ | Temps pour réaliser la variation de la vitesse pour le segment i | [s] $W_k^*$ |
| | Poids de l'arc du graphe adjoint | [Wh] |

Pour ces notations, la dérivée par rapport au temps est notée $\frac{d}{dt}$ ou par un point au-dessus de la variable considérée.

Le procédé selon l'invention comporte les étapes suivantes :

1) identification de la position du véhicule et de la quantité d'énergie stockée
2) construction d'un modèle dynamique du véhicule
3) construction d'un graphe adjoint
4) détermination de l'énergie consommée sur le graphe adjoint
5) détermination de la zone atteignable.

Les étapes de construction du modèle dynamique du véhicule et de construction du graphe adjoint peuvent être réalisées dans cet ordre, simultanément ou dans l'ordre inverse.

Le procédé selon l'invention peut être réalisé avant le départ du véhicule ou lorsque le véhicule est en déplacement. De préférence, le procédé selon l'invention est exécuté en temps réel.

Ainsi le procédé selon l'invention permet une gestion plus efficace de l'énergie, notamment une gestion plus efficace de la batterie d'un véhicule électrique.

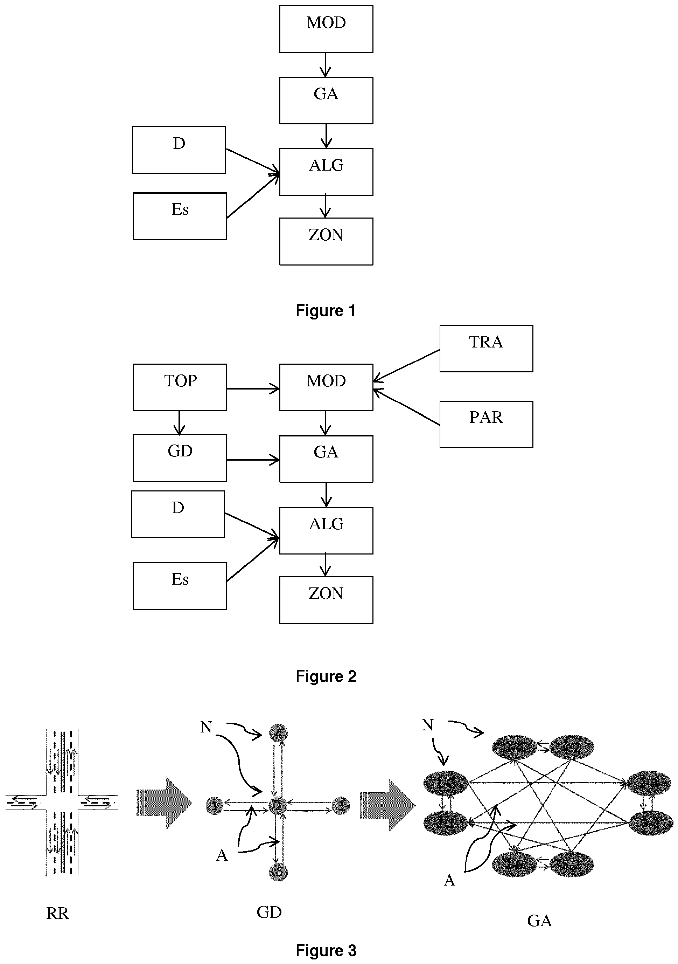

La figure 1 illustre, schématiquement et de manière non limitative, les étapes du procédé selon un mode de réalisation de l'invention.

1) identification de la position (D) et de la quantité d'énergie stockée (Es)
2) construction du modèle dynamique du véhicule (MOD)
3) construction du graphe adjoint (GA)
4) détermination de l'énergie consommée sur le graphe adjoint, au moyen du modèle dynamique (MOD) et du graphe adjoint (GA)
5) détermination de la zone atteignable (ZON) au moyen d'un algorithme de plus court chemin (ALG) appliqué au graphe adjoint (GA) contraint par la quantité d'énergie stockée (Es).

La figure 2 illustre, schématiquement et de manière non limitative, les étapes du procédé selon un deuxième mode de réalisation de l'invention. En plus des étapes décrites en relation avec la figure 1, le procédé comporte les étapes facultatives suivantes :

- détermination de la topologie du réseau routier (TOP), la topologie du réseau routier peut servir à la construction du modèle dynamique (MOD) et à la construction du graphe adjoint (GA),
- détermination du trafic routier (TRA), la détermination du trafic peut servir à la construction du modèle dynamique (MOD) et à la construction du graphe adjoint (GA),
- détermination des paramètres intrinsèques du véhicule (PAR), ces paramètres peuvent servir à la construction du modèle dynamique (MOD),
- construction d'un graphe direct (GD) du réseau routier, le graphe direct peut être obtenu au moyen de la topologie (TOP) du réseau routier, et peut servir à la construction du graphe adjoint (GA).

Les étapes de détermination de la topologie du réseau routier (TOP), du trafic routier (TRA) et des paramètres intrinsèques du véhicule (PAR) sont indépendantes. Il est donc possible de réaliser seulement une partie de ces étapes.

Toutes les étapes du procédé, y compris leurs variantes proposées sur la figure 2 sont décrites ci-dessous.

### 1) Identification de la position et de la quantité d'énergie stockée

Lors de cette étape, on identifie d'une part la position actuelle. En d'autres termes, on identifie le point de départ du véhicule.

La position actuelle du véhicule peut être identifiée au moyen d'un système de géolocalisation (par exemple de type GPS ou Galiléo). Alternativement, la position actuelle peut être indiquée par un utilisateur au moyen d'une interface avec celui-ci (par exemple un téléphone intelligent, le tableau de bord, ou un système de géolocalisation).

Lors de cette étape, on identifie d'autre part la quantité d'énergie stockée dans le véhicule. La quantité d'énergie stockée dans le véhicule correspond à l'énergie restante qui peut être utilisée par le véhicule. Il peut s'agir de la quantité totale d'énergie restante. Alternativement, l'utilisateur ou le concepteur du véhicule peut définir un seuil d'énergie à conserver (par exemple un niveau minimal de sécurité), dans ce cas, la quantité d'énergie stockée correspond à la différence entre l'énergie restante et le seuil d'énergie à conserver.

Pour un véhicule électrique, la quantité d'énergie stockée peut correspondre à l'état de charge de la batterie (noté SOC pour « State of Charge ») du véhicule. L'état de charge peut être mesuré par tout moyen connu.

Pour un véhicule thermique, la quantité d'énergie stockée peut correspondre à la quantité de carburant au sein du réservoir du véhicule. La quantité de carburant peut être mesurée par tout moyen connu.

Pour un véhicule hybride, la quantité d'énergie stockée peut correspondre à une conversion dans une même unité énergétique de l'état de charge de la batterie (SOC) et de la quantité de carburant du véhicule. L'état de charge et la quantité de carburant peuvent être mesurés par tout moyen connu.

### 2) Construction du modèle dynamique du véhicule

Lors de cette étape, on construit un modèle dynamique du véhicule. On appelle modèle dynamique du véhicule, un modèle qui relie l'énergie consommée par le véhicule à la vitesse et à l'accélération du véhicule. Le modèle dynamique du véhicule peut être construit au moyen du principe fondamental de la dynamique, associé à un modèle énergétique de la motorisation.

Selon une mise en œuvre de l'invention (cf. étape de détermination des paramètres intrinsèques du véhicule de la figure 2), le modèle peut être construit à partir de paramètres macroscopiques du véhicule, par exemple : motorisation du véhicule, masse du véhicule, puissance maximale, vitesse maximale, type de transmission, paramètres aérodynamiques, etc.. Ainsi, le modèle dynamique est représentatif du véhicule, et prend en compte ses caractéristiques spécifiques.

Selon une variante de réalisation, les paramètres macroscopiques peuvent être obtenus depuis une base de données, qui répertorie les différents véhicules en circulation. Par exemple, les paramètres macroscopiques peuvent être obtenus en indiquant le numéro d'immatriculation du véhicule, la base de données associant le numéro de plaque à sa conception (marque, modèle, motorisation...), et comprenant les paramètres macroscopiques du véhicule.

Alternativement, les paramètres macroscopiques peuvent être des données constructeurs renseignées par l'utilisateur, en particulier au moyen d'une interface (par exemple un téléphone intelligent, le tableau de bord, ou un système de géolocalisation).

Le modèle dynamique du véhicule peut également dépendre de paramètres de la route, tels que la pente de la route. De telles données peuvent être obtenues à partir d'une topologie (cf. étape de détermination de la topologie de la figure 2) ou d'une cartographie du réseau routier.

Le modèle dynamique du véhicule prend en compte la dynamique du véhicule. Il peut être construit à partir de l'application du principe fondamental de la dynamique du véhicule appliqué sur son axe longitudinal, et peut s'écrire sous la forme suivante :

$$m\frac{dv(t)}{dt} = F_w - F_{aero} - F_{friction} - F_{slope}$$

Où $m$ est la masse du véhicule, $v(t)$ sa vitesse, $F_w$ la force à la roue, $F_{aero}$ la force aérodynamique, $F_{friction}$ la force de résistance au roulement, $F_{slope}$ la force gravitationnelle. Donc, le modèle peut être réécrit :

$$\begin{cases} \dot{x}(t) = v(t) \\ m\dot{v}(t) = F_w - \frac{1}{2}\rho_a A_f c_d v(t)^2 - mgc_r - mg\sin\big(\alpha(x)\big) \end{cases}$$

Où $\rho_a$ est la densité de l'air, $A_f$ la surface frontale du véhicule, $c_d$ le coefficient de résistance aérodynamique, $c_r$ le coefficient de résistance au roulement, $\alpha(x)$ la pente de la route en fonction de la position, et $g$ l'accélération gravitationnelle. La somme des pertes aérodynamiques et de roulement sont généralement approximées avec un polynôme de second ordre en fonction de la vitesse $v$ :

$$F_{res} = F_{aero} + F_{friction} = a_2 v(t)^2 + a_1 v(t) + a_0$$

Où les paramètres $a_0$, $a_1$ et $a_2$ peuvent être identifiés pour le véhicule considéré à partir d'un essai standard appelé « coast down », signifiant pente descendante.

Donc, la force à la roue peut être exprimée comme :

$$F_w = m\dot{v}(t) + a_2 v(t)^2 + a_1 v(t) + a_0 + mg\sin\big(\alpha(x)\big)$$

Dans la suite, le modèle dynamique du véhicule est décrit pour un mode de réalisation non limitatif d'un véhicule électrique. Le véhicule électrique comprend au moins une machine électrique, au moins un moyen de stockage de l'énergie électrique (telle qu'une batterie) pour alimenter le moteur électrique ou pour être alimentée par la machine électrique (dans le cas de freinage récupératif) et des moyens de récupération de l'énergie, notamment des moyens de freinage récupératif. Toutefois, le modèle est adaptable à tout type de motorisation (thermique, hybride, électrique).

Le couple demandé à la machine électrique pour réaliser la force requise à la roue est défini comme (dans les équations « if » est la traduction anglaise de « si ») :

$$T_m = \begin{cases} \dfrac{F_w r}{\rho_t \eta_t}, & if \ \ F_w \geq 0 \\[2em] \dfrac{F_w r \eta_t}{\rho_t}, & if \ \ F_w < 0 \end{cases}$$

Où $r$ est le rayon de roue, $\rho_t$ et $\eta_t$ sont le rapport de transmission et le rendement de transmission. Une machine électrique est en général une machine réversible, donc elle se comporte comme un moteur quand $T_m$ est positif et comme un générateur (récupération d'énergie) quand $T_m$ est négatif. Le couple généré par la machine électrique est saturé par $T_{m,max}$ et $T_{m,min}$. En particulier, pendant les phases de freinage, si le couple moteur est moins négatif que la valeur de saturation $T_{m,min}$, alors le véhicule n'est freiné que par le système de freinage récupératif. Autrement, le frein mécanique intervient en ajoutant son action au freinage récupératif.

La puissance disponible à l'arbre moteur, en présence d'un système de freinage récupératif, peut être définie comme :

$$P_m = \begin{cases} T_{m,max}\omega(t), & if \ T_m \geq T_{m,max} \\ T_m\omega(t), & if \ T_{m,min} < T_m < T_{m,max} \\ T_{m,min}\omega(t), & if \ T_m \leq T_{m,min} \end{cases}$$

Où $\omega_t$ est le régime moteur qui est défini comme :

$$\omega(t) = \frac{v(t)\rho_t}{r}$$

La demande de puissance à la batterie est exprimée comme suit :

$$P_b = \begin{cases} \dfrac{P_m}{\eta_b}, & if \ \ P_m \geq 0 \\[2em] P_m\eta_b, & if \ \ P_m < 0 \end{cases}$$

Où $\eta_b$ est le rendement agrégé de la chaine de traction électrique (onduleur, batterie, etc.).

Selon un mode de réalisation de l'invention, pour améliorer la précision du modèle et de l'estimation de la consommation énergétique d'un trajet, on peut tenir compte de la demande de puissance d'au moins un système auxiliaire dans le modèle de dynamique du véhicule. En effet, la puissance demandée par le conducteur pour le confort, notamment pour le chauffage de l'habitacle ou pour l'air conditionné, est particulièrement onéreuse en termes de consommation énergétique, notamment pour un véhicule électrique sur lequel le chauffage peut avoir un impact très fort sur l'autonomie. Le terme de puissance demandée par les auxiliaires peut être exprimé comme une fonction de la température ambiante :

$$P_{aux} = K(T_{amb})$$

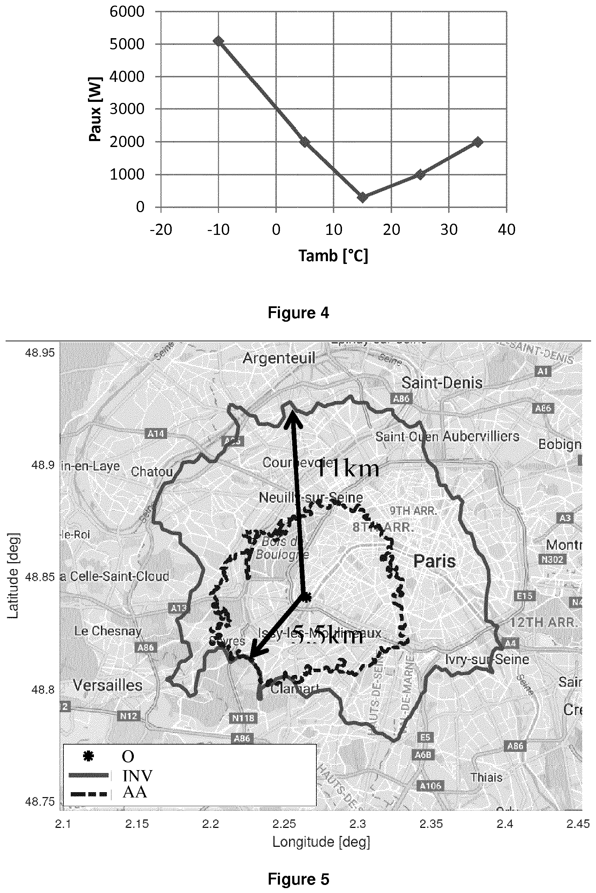

Un exemple non limitatif de cette fonction qui relie la Puissance auxiliaire $P_{aux}$ à la température ambiante $T_{amb}$ est illustrée en figure 4. Pour l'exemple illustré, la fonction est une fonction affine par morceaux, qui est décroissante pour les températures peu élevées (chauffage de l'habitacle) puis croissante pour les températures élevées (climatisation de l'habitacle).

Donc, pour ce mode de réalisation, la consommation énergétique à la batterie sur un horizon temporel $T$ peut être définie comme :

$$E_b = \int_0^T P_b + P_{aux} \, dt$$

Le modèle décrit ci-dessus requiert un signal de vitesse instantanée. Cette information n'est pas disponible à priori sur les segments de route (portions de route du réseau routier), sur lesquels les seules informations disponibles sont des vitesses moyennes.

Selon l'invention, on considère dans un premier temps une vitesse moyenne sur chaque segment de route, puis on considère l'accélération du véhicule pour atteindre cette vitesse moyenne depuis le segment précédent. De préférence, la vitesse moyenne peut être obtenue à partir d'informations sur le trafic routier sur le réseau routier.

Selon une variante, la vitesse moyenne sur un segment peut être obtenue en temps réel par communication avec des services de données en ligne, qui acquièrent en temps réel des informations sur la circulation sur le réseau routier. Cette étape facultative de détermination du trafic est décrite pour le mode de réalisation de la figure 2.

Alternativement, la vitesse moyenne peut être stockée par des moyens de stockage de données historiques, qui stockent des données de circulation sur le réseau routier, notamment pour différents jours, différentes heures....

Ainsi, si on suppose connue la vitesse moyenne $\bar{v}$ due au trafic d'un segment de route, on peut modifier le modèle décrit ci-dessus pour estimer la consommation énergétique du véhicule pour parcourir le segment de route considéré. Par la suite, on remplace dans le modèle dynamique la vitesse $v(t)$ par la vitesse moyenne du trafic $\bar{v}$. On suppose, donc, que tous les véhicules sur le segment de route $i$ roulent à la vitesse $\bar{v}_i$. Donc, l'expression de la force à la roue est modifiée pour chaque segment de route i :

$$\bar{F}_{w,i} = a_2 \bar{v}_i^2 + a_1 \bar{v}_i + a_0 + mg \sin\big(\alpha_i(x)\big)$$

Où le terme d'accélération disparait. Le couple moteur devient :

$$\bar{T}_{m,i} = \begin{cases} \dfrac{\bar{F}_{w,i}r}{\rho_t \eta_t}, & if \quad \bar{F}_{w,i} \geq 0 \\[2ex] \dfrac{\bar{F}_{w,i}r\eta_t}{\rho_t}, & if \quad \bar{F}_{w,i} < 0 \end{cases}$$

Le régime moteur est aussi constant dans le temps puisque on assume une vitesse constante $\bar{v}_i$ :

$$\bar{\omega}_i = \frac{\bar{v}_i \rho_t}{r}$$

La puissance mécanique disponible à la machine électrique est réécrite comme suit :

$$\bar{P}_{m,i} = \begin{cases} T_{m,max} \cdot \bar{\omega}_i, & if \quad \bar{T}_{m,i} \geq T_{m,max} \\ \bar{T}_{m,i} \cdot \bar{\omega}_i, & if \quad T_{m,min} < \bar{T}_{m,i} < T_{m,max} \\ T_{m,min} \cdot \bar{\omega}_i, & if \quad \bar{T}_{m,i} \leq T_{m,min} \end{cases}$$

Dans ce qui suit, on suppose que les valeurs de saturation du couple sont indépendantes du régime moteur. Toutefois, d'autres modes de réalisation sont valables, notamment les couples maximal et minimal peuvent être dépendants du régime moteur.

La demande de puissance à la batterie du véhicule électrique peut être définie comme :

$$\bar{P}_{b,i} = \begin{cases} \dfrac{\bar{P}_{m,i}}{\eta_b}, & if \quad \bar{P}_{m,i} \geq 0 \\[2ex] \bar{P}_{m,i}\eta_b, & if \quad \bar{P}_{m,i} < 0 \end{cases}$$

La consommation énergétique de la batterie est donc :

$$\bar{E}_{b,i} = \left(\bar{P}_{b,i} + P_{aux}\right)T_i$$

Où $T_i = l_i/\bar{v}_i$ est le temps de parcours sur le segment de route $i$ si on roule à la vitesse moyenne du trafic $\bar{v}_i$.

L'utilisation de la vitesse moyenne dans les modèles de consommation énergétique représente une approche standard dans l'art antérieur. Le procédé selon l'invention propose la prise en compte de l'accélération dans le modèle dynamique du véhicule pour une estimation plus précise et fiable de la vraie consommation. Pour la prise en compte des phénomènes d'accélération, le parcours sur chaque segment de route est divisé en deux phases : une phase à vitesse de croisière constante $\bar{v}_i$, et une phase de variation de la vitesse (c'est-à-dire d'accélération ou de décélération) pour aller de la vitesse $\bar{v}_{i-1}$, c'est-à-dire la vitesse moyenne du segment précédent, à la vitesse $\bar{v}_i$, c'est-à-dire la vitesse moyenne du segment actuel. De préférence, on considère une accélération (ou une décélération) constante pour atteindre la vitesse $\bar{v}_i$. Donc, même si les informations macroscopiques disponibles ne permettent pas de connaître l'information temporelle, l'accélération spatiale ayant lieu à l'interface entre deux segments de route est considérée. La consommation d'énergie $E_{jump,i}$ associée avec la variation de vitesse entre deux segments de route est définie comme :

$$E_{jump,i} = \int_0^{t_{jump,i}} \left(\tilde{P}_{b,i} + P_{aux}\right) dt$$

Avec $\tilde{P}_{b,i}$ la demande de puissance à la batterie pour la phase d'accélération pour aller de la vitesse $\bar{v}_{i-1}$ à la vitesse $\bar{v}_i$.

Une telle demande de puissance à la batterie peut être obtenue, comme vu précédemment, à partir d'une force à la roue d'interface définie comme :

$$\tilde{F}_w = m \cdot a + a_2 v(t)^2 + a_1 v(t) + a_0$$

Où la vitesse variante dans le temps v(t) dans chaque transitoire peut être ici linéairement modélisée comme :

$$v(t) = \bar{v}_{i-1} + sign(\bar{v}_i - \bar{v}_{i-1}) \cdot a \cdot t$$

Où $\bar{v}_{i-1}$ est la vitesse sur le segment en amont, $\bar{v}_i$ est la vitesse sur le segment en aval, $a$ est l'accélération constante pour réaliser le changement de vitesse. La variation de vitesse est donc réalisée en :

$$t_{jump,i} = \frac{\bar{v}_i - \bar{v}_{i-1}}{sign(\bar{v}_i - \bar{v}_{i-1}) \cdot a}$$

La consommation totale d'énergie sur le segment i est ainsi définie :

$$E_{b,i} = \bar{E}_{b,i} + E_{jump,i}$$

La prise en compte des accélérations d'interface améliore la précision de l'estimation énergétique, et par conséquent la précision et la fiabilité de la détermination des zones atteignables.

Cependant, les informations disponibles à priori ne sont pas toujours complètes ou à jour. Notamment, il n'est pas probable d'avoir des informations précises sur les vitesses moyennes du trafic pour des rues secondaires. Par conséquent, il est possible d'avoir des longues portions de route sur lesquelles la vitesse du trafic sera simplement une valeur nominale constante. Dans ce cas, une prise en compte uniquement des données du réseau routier consisterait à supposer qu'il n'y ait aucune accélération ce qui générerait de grosses erreurs dans l'estimation de la consommation énergétique. C'est la raison pour laquelle l'invention permet également d'enrichir les données sur le réseau routier en intégrant les perturbations de vitesse induites par des éléments critiques de l'infrastructure routière, notamment les feux tricolores, les intersections et les virages. Par exemple, si on sait qu'un feu de signalisation est localisé à l'interface entre deux segments, on tient compte de son impact dans l'estimation de la consommation, en prenant compte de la variation de la vitesse entre les deux segments.

La prise en compte de ces accélérations permet, non seulement d'obtenir des coûts énergétiques plus réalistes et précis, mais également d'éviter des boucles négatives dans le graphe de routage qui modélise le réseau routier. En effet, la boucle négative représente une séquence de segments de route qui a le même point de départ et d'arrivée avec un coût total négatif. Dans le cas spécifique d'un graphe pondéré avec des poids énergétiques, cela représente une situation de récupération infinie d'énergie si on parcourt la boucle en continu, ce qui est impossible en réalité. Cette criticité se vérifie facilement si on considère des véhicules électriques et si l'estimation de la consommation sur un segment de route et de ses voisins ne tient pas en compte d'éléments importants comme la pente et/ou les accélérations pour transiter d'un segment au suivant. La présence de boucles négatives dans le graphe de routage empêche de trouver un trajet qui minimise globalement la consommation, car l'algorithme de recherche irait converger de façon triviale sur ces boucles pour réduire la consommation.

Conformément à une mise en œuvre de l'invention, la variation de vitesse entre les deux segments peut être modélisée comme deux transitoires : le premier pour aller de la vitesse $\bar{v}_{i-1}$ à 0 (arrêt du véhicule, par exemple à un feu tricolore), et le seconde pour aller de 0 à la vitesse $\bar{v}_i$. Donc, la consommation d'énergie, liée à la variation de la vitesse peut être décrite comme la somme de deux contributions :

$$E_{jump,i} = \int_0^{t_{jump1,i}} (\tilde{P}_{b1,i} + P_{aux}) \, dt + \int_0^{t_{jump2,i}} (\tilde{P}_{b2,i} + P_{aux}) \, dt$$

Où la variation de vitesse dans le premier terme est modélisée comme :

$$v_1(t) = \bar{v}_{i-1} - a \cdot t$$

Et le temps pour réaliser la première variation :

$$t_{jump1,i} = \bar{v}_{i-1}/a$$

De même, la variation de vitesse dans le deuxième terme est modélisée comme :

$$v_2(t) = a \cdot t$$

Et le temps pour réaliser cette variation :

$$t_{jump2,i} = \bar{v}_i/a$$

Par conséquent, selon l'invention, le modèle dynamique du véhicule peut s'écrire (pour tout type de véhicule) :

$$E_i = \bar{P}_i T_i + \int_0^{t_{jump,i}} \tilde{P}_i \, dt$$

Avec $E_i$ l'énergie consommée sur le segment $i$, $\bar{P}_i$ la puissance demandée au système de stockage d'énergie du véhicule (réservoir de carburant, batterie, etc.) lorsque le véhicule est considéré à vitesse constante sur le segment $i$, $T_i$ le temps pendant lequel le véhicule est considéré à vitesse constante sur le segment $i$, $\tilde{P}_i$ la puissance demandée au système de stockage d'énergie du véhicule lorsque le véhicule est considéré ayant une variation de vitesse (variation de vitesse entre le segment $i$ - 1 et le segment $i$), et $t_{jump,i}$ le temps pour réaliser la variation de vitesse. Le premier terme du modèle correspondant à l'énergie consommée sur le segment due à la vitesse moyenne, et le deuxième terme correspond à l'énergie consommée due à la variation de vitesse pour atteindre la vitesse moyenne.

Pour le mode de réalisation, selon lequel on prend en compte la demande de puissance d'au moins un système auxiliaire, le modèle dynamique du véhicule peut s'écrire (pour tout type de véhicule) :

$$E_i = (\bar{P}_i + P_{aux})T_i + \int_0^{t_{jump,i}} (\tilde{P}_i + P_{aux})\, dt$$

Avec $E_i$ l'énergie consommée sur le segment $i$, $\bar{P}_i$ la puissance demandée au système de stockage d'énergie du véhicule (réservoir de carburant, batterie, etc.) lorsque le véhicule est considéré à vitesse constante sur le segment $i$, $P_{aux}$ la demande de puissance d'au moins un système auxiliaire, $T_i$ le temps pendant lequel le véhicule est considéré à vitesse constante sur le segment $i$, $\tilde{P}_i$ la puissance demandée au système de stockage d'énergie du véhicule lorsque le véhicule est considéré ayant une variation de vitesse (variation de vitesse entre le segment $i - 1$ et le segment $i$), et $t_{jump,i}$ le temps pour réaliser la variation de vitesse. Le premier terme du modèle correspondant à l'énergie consommée sur le segment due à la vitesse moyenne, et le deuxième terme correspond à l'énergie consommée due à la variation de vitesse pour atteindre la vitesse moyenne.

On rappelle que pour un véhicule électrique, l'énergie consommée peut être négative. En effet, le freinage peut permettre de récupérer de l'énergie dans la batterie.

### 3) Construction du graphe adjoint

Lors de cette étape, on construit un graphe adjoint du réseau routier. On appelle, en théorie des graphes, un graphe adjoint d'un graphe $G$ (dans ce cas le réseau routier), un graphe qui représente la relation d'adjacence entre les arêtes de $G$. Le graphe adjoint d'un graphe peut être défini de la manière suivante : chaque sommet du graphe adjoint représente une arête (appelé également arc) du graphe $G$, et deux sommets du graphe adjoint sont adjacents (c'est-à-dire reliés) si et seulement si les arêtes correspondantes partages une extrémité commune dans le graphe $G$. Ainsi, le graphe adjoint est une représentation équivalente du réseau routier où toutes les manœuvres sont correctement découplées et distinguées, ce qui permet une détermination précise des coûts énergétiques. L'utilisation d'un graphe adjoint permet une réduction de la mémoire nécessaire pour la détermination de la zone atteignable par rapport à l'utilisation d'un graphe direct. En effet, la structure de données est moins complexe pour un graphe adjoint.

Pour les méthodes selon l'art antérieur, le réseau routier peut être modélisé comme un graphe orienté (« Directed Graph »). Soit le graphe $G = (V,A)$, où $V$ est l'ensemble des nœuds et $A$ est l'ensemble des connections entre les nœuds, c'est-à-dire les arcs. Soit $w{:}A \rightarrow W$ une fonction qui assigne un poids à chaque arc du graphe. Dans les graphes utilisés pour la navigation conventionnelle, le poids associé aux arcs représente soit la longueur soit le temps de parcours. Pour le procédé selon l'invention, chaque poids représente la consommation énergétique pour parcourir l'arc.

Selon un mode de réalisation de l'invention, l'objectif de ce travail peut être de concevoir une stratégie fondée uniquement sur des informations statistiques et topologiques du réseau routier, sans aucune utilisation de données réelles de conduite. Ce type d'informations, bien souvent incomplètes et/ou imprécises, est généralement disponible sur des web-services (services en ligne) de cartographie payants. Pour chaque arc $i \in A$ du graphe, il est possible de connaître la longueur, la vitesse moyenne du trafic actuelle $v_i$ qui dépend de l'heure de la journée, et la pente de $\alpha_i(x)$ qui varie à l'intérieur de l'arc considéré en fonction de la position. En outre, certains web-services de cartographie fournissent un degré d'importance de chaque segment de route, en précisant si c'est une autoroute, un grand axe urbain, ou une rue urbaine secondaire. En outre, la position de certains feux de circulation peut être disponible.

Au moyen du procédé selon l'invention, il est possible d'améliorer considérablement la précision de l'estimation de la consommation d'énergie et de la navigation compte tenu des accélérations induites par les différentes vitesses dans les segments de route et/ou par les éléments de l'infrastructure connus.

La prise en compte des accélérations d'interface entre les arcs adjacents pose un problème dans la modélisation du réseau routier en tant que graphe direct (art antérieur) et surtout dans l'assignation des poids à chaque arc. En particulier, chaque nœuds du graphe avec deux ou plus arcs entrants est critique car $v_{i-1}$ et par conséquent $E_{jump,i}$ ne sont pas uniques. Evidemment, ce fait empêche une assignation non ambiguë des poids sur les arcs. Donc, le graphe direct $G$ n'est pas adéquat pour le modèle de consommation énergétique proposé. Cette ambiguïté peut être résolue en utilisant le graphe adjoint comme graphe pour la stratégie de navigation proposée.

Selon l'invention, on construit le graphe adjoint du réseau routier en mettant en œuvre les étapes suivantes :

i) on construit un graphe direct dudit réseau routier avec des nœuds et des arcs (également appelés segments ou arêtes), les nœuds du graphe direct correspondant aux intersections du réseau routier, et les arcs du graphe direct correspondant aux routes reliant les intersections ; et

ii) on construit le graphe adjoint dudit réseau routier avec des nœuds et des arcs, les nœuds du graphe adjoint correspondant aux arcs du graphe direct et les arcs du graphe adjoint correspondant à l'adjacence desdits arcs du graphe direct.

La figure 3 illustre de manière schématique et non limitative ces étapes de construction du graphe adjoint. Le réseau routier RR concerne une intersection entre deux routes. La première étape consiste à construire le graphe direct GD depuis le réseau routier. Le graphe direct GD comprend cinq nœuds N, correspondant aux quatre extrémités des routes et à l'intersection de celles-ci. De plus, le graphe direct GD comprend huit arcs A reliant les nœuds et correspondant aux routes du réseau routier RR. La deuxième étape consiste à construire le graphe adjoint GA à partir du graphe direct GD. Le graphe adjoint GA comprend huit nœuds N correspondant à chaque arc du graphe direct GD. De plus, le graphe adjoint GA comprend vingt arcs A correspondant à l'adjacence des nœuds N du graphe direct GD.

4) Détermination de l'énergie consommée pour chaque arc du graphe adjoint

Lors de cette étape, on détermine un poids à chaque arc du graphe adjoint. Le poids correspond à l'énergie consommée par le véhicule sur cet arc. Pour cela, on applique le modèle dynamique du véhicule pour chaque arc du graphe adjoint, en considérant la vitesse moyenne du véhicule sur cet arc, et l'accélération du véhicule pour atteindre la vitesse moyenne. Ainsi, il est possible de connaître de manière précise l'énergie consommée sur un arc, ce qui permet de déterminer un itinéraire optimal en termes de dépenses énergétiques.

L'utilisation du graphe adjoint $L(G)$ comme graphe de routage permet d'assigner de façon unique le poids à chaque arc du graphe, en découplant toutes les manœuvres possibles modélisées dans le graphe original $G$. Chaque arc du graphe adjoint représente un trajet sur deux arcs adjacents du graphe direct $G$, et donc chaque arc du graphe adjoint $L(G)$ contient des informations sur un arc du graphe direct original $G$ et aussi sur son arc en amont.

Cette propriété intrinsèque du graphe adjoint permet non seulement de considérer correctement les accélérations d'interface entre arcs adjacents, mais aussi de modéliser d'une manière plus réaliste l'impact de l'infrastructure sur la consommation d'énergie. Plus spécifiquement, selon une approche de modélisation proposée, le terme énergétique qui prend en compte les arrêts/redémarrages induits par l'infrastructure

$$E_{jump,i} = \int_0^{t_{jump1,i}} (\tilde{P}_{b1,i} + P_{aux})\, dt + \int_0^{t_{jump2,i}} (\tilde{P}_{b2,i} + P_{aux})\, dt$$

Cette considération peut être introduite uniquement sur les arcs du graphe adjoint qui représentent les situations suivantes :

- un feu de circulation ou un panneau d'arrêt est situé à la jonction entre une route en amont de priorité inférieure et une route en aval de priorité supérieure. De cette façon, les ondes vertes sur les grands axes ne sont pas pénalisées.
- les arcs en amont et en aval sont connectés par une manœuvre avec un angle de virage plus large qu'un seuil réglable.

Le graphe adjoint $L(G) = (V^*, A^*)$ d'un graphe $G$ a comme nœuds les arcs du graphe $G$, donc $i \in A$ mais aussi $i \in V^*$. Donc, soit $w^*: A^* \to W^*$ une nouvelle fonction d'assignation de poids aux arcs du graphe adjoint. Le poids pour chaque arc $k \in A^*$ est défini comme suit :

$$W_k^* = \begin{cases} \bar{E}_{b,i} + E_{jump,i}, & si\ i-1 \in V^*\ a\ des\ arcs\ entrants \\ \bar{E}_{b,i} + E_{jump,i} + \bar{E}_{b,i-1}, & si\ i-1 \in V^*\ n'a\ pas\ d'arcs\ entrants \end{cases}$$

On rappelle que pour un véhicule électrique, l'énergie sur un arc peut être négative. Par conséquent, le poids de cet arc du graphe adjoint peut être négatif. En effet, le freinage peut permettre de récupérer de l'énergie dans la batterie.

5) Détermination de la zone atteignable

Lors de cette étape, on détermine au moins une zone du réseau routier qui est atteignable par le véhicule avec la quantité d'énergie stockée en partant de la position identifiée. Cette zone atteignable est déterminée par une méthode qui minimise la consommation énergétique. La zone atteignable peut être définie par une représentation graphique sur une carte routière. Par exemple, la représentation graphique peut consister en l'ensemble des points (positions) du réseau routier que peut atteindre le véhicule, ces points peuvent être inscrits dans un polygone. La zone atteignable peut ne pas être une zone « pleine » : au sein du pourtour délimitant la zone, des zones (ou points) critiques non atteignables peuvent exister. Il peut s'agir par exemple de zones (ou points) critiques correspondant à des collines, montagnes, etc. Ainsi la zone atteignable peut être un polygone, au sein duquel les zones critiques sont exclues.

Cette étape est réalisée en prenant en compte l'énergie consommée sur chaque arc du graphe adjoint. La détermination de la zone atteignable est mise en œuvre par un algorithme de chemin le plus court. L'algorithme de chemin le plus court détermine la zone atteignable sur le graphe adjoint en prenant en compte l'énergie consommée déterminée pour chaque arc. De préférence, l'algorithme optimal qui calcule le plus court chemin dans un graphe orienté et pondéré à partir d'un sommet source est l'algorithme de Bellman-Ford. L'algorithme choisi est apte à prendre en compte un poids (c'est-à-dire une énergie consommée) négatif sur au moins un arc du graphe adjoint, à la différence d'autres algorithmes comme celui de Dijkstra qui, bien que plus rapide, n'est pas optimal en présence d'arcs avec poids négatifs. L'utilisation d'un algorithme de plus court chemin permet de déterminer la zone atteignable la plus étendue possible (de manière moins conservative que les procédés selon l'art antérieur). Ainsi, l'autonomie du véhicule est accrue.

Une fois que l'algorithme restitue la séquence optimale de nœuds du graphe adjoint, ce résultat peut être facilement reporté sur le graphe original, en générant l'ensemble des de nœuds du graphe original entourant l'origine du déplacement, c'est-à-dire la zone atteignable.

Selon une mise en œuvre de l'invention, le procédé peut comporter une étape d'enregistrement hors ligne des informations globales historiques sur les conditions de trafic de différents jours d'une semaine choisie à différentes heures de la journée. L'adaptation en temps réel est mise en œuvre seulement après que le conducteur sélectionne le point de départ, et l'heure de départ.

Une étape facultative du procédé selon l'invention peut consister à afficher la zone atteignable déterminée, par exemple sur un écran d'un système de géolocalisation (GPS, Galiléo), d'un téléphone intelligent, sur le tableau de bord du véhicule, sur un site internet, etc. Ainsi, il est possible d'informer l'utilisateur ou tout autre personne (par exemple un gestionnaire de flotte de véhicules, un responsable d'infrastructure routière...) de la zone atteignable. Il est également possible d'afficher l'énergie consommée pour les points de la zone atteignable.

L'affichage de la zone atteignable peut consister à représenter sur une carte du réseau routier, l'ensemble des points (positions) que peut atteindre le véhicule.

En outre, le procédé selon l'invention peut être utilisé pour déterminer la zone atteignable en prévoyant un trajet aller-retour. En effet, une extension du procédé selon l'invention particulièrement attractif dans le cas des véhicules électriques, peut consister à calculer du rayon d'action lorsque des trajets aller-retour sont envisagés. Pour un véhicule électrique, il est intéressant de connaître non seulement la possibilité d'atteindre ou non une destination, mais aussi la capacité de retour au point d'origine pour recharger.

Ce résultat peut être obtenu en utilisant l'algorithme de chemin le plus court, par exemple l'algorithme de Bellman-Ford, sur le graphe adjoint « inversé ». Ce graphe est obtenu simplement en inversant le sens des arcs du graphe adjoint original. Ensuite, l'algorithme de chemin le plus court (Bellman-Ford) peut être exécuté sur ce graphe ayant toujours comme nœud source la même origine. Cela permet d'obtenir tous les chemins optimaux pour atteindre la position de départ à partir de tous les autres nœuds du graphe adjoint.

Selon un mode de réalisation de l'invention, on estime la consommation énergétique du véhicule depuis l'origine vers au moins un point de la zone atteignable. De préférence, on détermine la consommation énergétique pour tous les points de la zone atteignable. En effet, le fait d'utiliser un modèle dynamique et un algorithme de plus court chemin, en particulier l'algorithme de Bellman Ford, permet d'estimer la consommation énergétique de l'origine vers toutes les destinations à l'intérieur de la zone atteignable. Donc, dans la zone atteignable, on peut connaitre comment la consommation énergétique varie en fonction des différentes destinations possibles. Ainsi, il est possible d'optimiser la gestion de la charge de la batterie du véhicule en fonction de la destination et de la zone atteignable. Selon une variante de réalisation de ce mode de réalisation, on peut également afficher la consommation énergétique estimée, par exemple sur un écran d'un système de géolocalisation (GPS, Galiléo), d'un téléphone intelligent, sur le tableau de bord du véhicule, sur un site internet, etc.

Conformément à un mode de réalisation selon l'invention, le procédé selon l'invention peut être utilisé comme un outil permettant de calibrer une approche simplifiée de type iso-distance. L'approche iso-distance est une approche connue qui consiste à déterminer une distance que peut parcourir le véhicule en fonction de la quantité d'énergie stockée, et à appliquer cette distance au point de départ du véhicule. Cette approche iso-distance détermine donc une zone sensiblement circulaire de rayon constant autour du point de départ. Une telle application permet de fonctionner avec des ressources très limitées, à la fois en termes de requêtes de données cartographiques et de puissance de calcul.

Dans une telle démarche, la présente invention est utilisée une fois pour concevoir l'approche simplifiée, qui sera ensuite utilisée de manière indépendante. L'invention permet alors de calibrer l'autonomie kilométrique correspondant à un véhicule donné et à une zone géographique donnée. Après cette calibration hors ligne de l'algorithme iso-distance avec le procédé selon l'invention, on applique l'algorithme iso-distance calibré en ligne pour déterminer les zones atteignables. Dans cette application, l'autonomie résultante n'est plus optimale mais sera correspondante au pire cas de l'approche optimale et peut donc avoir la valeur maximale admissible avec une approche iso-distance, plus fiable et plus précise qu'une approche iso-distance sans calibration.

Le procédé selon l'invention peut être utilisé pour les véhicules automobiles. Toutefois, il peut être utilisé dans le domaine du transport routier, le domaine des deux-roues, etc...

En outre, le procédé selon l'invention concerne un procédé de gestion d'une batterie d'un véhicule, électrique ou hybride, circulant au sein d'un réseau routier. La gestion de la batterie peut comporter les étapes suivantes :

- on détermine au moins une zone du réseau routier atteignable par le véhicule au moyen du procédé de détermination selon l'une des variantes décrites précédemment, en fonction de la position de départ et de la quantité d'énergie stockée dans la batterie, et
- on gère l'utilisation et/ou la charge de la batterie en fonction de la zone atteignable.

La gestion de l'utilisation et/ou de la charge de la batterie peut consister à déterminer au sein de la zone atteignable une destination pour le véhicule. La destination peut être la destination finale pour le véhicule ou une station de charge du véhicule, si la destination finale souhaitée par l'utilisateur est en dehors de la zone atteignable. Alternativement, la gestion de l'utilisation et/ou la charge de la batterie peut consister à retarder et/ou avancer son trajet de manière à ce que la batterie soit complètement chargée. Par exemple, si la destination finale souhaitée par l'utilisateur n'est pas dans la zone atteignable, l'utilisateur peut charger la batterie jusqu'à ce que sa destination finale souhaitée soit dans la zone atteignable. Alternativement, si l'utilisateur constate qu'il ne pourra faire le trajet souhaité, il peut avancer et/ou modifier son trajet pour charger au plus tôt la batterie.

Pour le mode de réalisation pour lequel on détermine la consommation énergétique pour la zone atteignable, la gestion de l'utilisation et/ou de la charge de la batterie peut être réalisée en fonction de la consommation énergétique déterminée, de manière à optimiser cette gestion.

Grâce à la précision et la fiabilité du procédé de détermination de la zone atteignable, la gestion de la batterie du véhicule est plus efficace qu'avec les procédés selon l'art antérieur. Ainsi, l'autonomie de la batterie du véhicule est accrue.

L'invention concerne par ailleurs un produit programme d'ordinateur téléchargeable depuis un réseau de communication et/ou enregistré sur un support lisible par ordinateur et/ou exécutable par un processeur ou un serveur. Ce programme comprend des instructions de code de programme pour la mise en œuvre du procédé tel que décrit ci-dessus, lorsque le programme est exécuté sur un ordinateur ou un téléphone portable ou tout système analogue.

Exemples d'application

Les caractéristiques et avantages du procédé selon l'invention apparaîtront plus clairement à la lecture des exemples d'applications ci-après.

*Exemple 1*

Cet exemple 1 concerne une comparaison du procédé selon l'invention avec un procédé selon l'art antérieur de type iso-distance.

On rappelle que l'approche iso-distance est une approche connue qui consiste à déterminer une distance que peut parcourir le véhicule en fonction de la quantité d'énergie stockée, et à appliquer cette distance au point de départ du véhicule. Cette approche iso-distance détermine donc une zone sensiblement circulaire de rayon constant autour du point de départ.

Pour cette comparaison, on estime un point de départ commun et une quantité d'énergie restante de 1kWh. Pour l'approche iso-distance selon l'art antérieur, cette quantité d'énergie restante correspond à une distance à parcourir de 5,5 km.

La figure 5 illustre, sur une carte de la région parisienne, les résultats obtenus pour le procédé iso-distance AA. La figure 5 illustre, sur la même carte, la région atteignable depuis l'origine O pour le procédé selon l'invention INV.

Ainsi, la comparaison entre l'approche énergétique de la présente invention INV et l'état de l'art AA permet de montrer d'une part que le procédé selon l'invention permet de donner une prédiction moins pessimiste : il est possible d'atteindre des points situés à 11 km de l'origine, soit deux fois la distance prévue par le procédé selon l'art antérieur. D'autre part, le polygone obtenu avec l'approche énergétique (selon l'invention) n'est pas aussi symétrique celui de l'approche iso-distance (selon l'art antérieur), cela montre l'impact de tous les facteurs qui impactent la consommation énergétique (pente, trafic, signalisation, etc.) qui ne sont pas pris en compte dans l'approche de l'art antérieur. Ainsi, le procédé selon l'invention permet de déterminer un rayon énergétique fiable et en accord avec la réalité du réseau routier

*Exemple 2*

Cet exemple 2 concerne également une comparaison du procédé selon l'invention avec un procédé selon l'art antérieur de type iso-distance.

Pour cette comparaison, on estime un point de départ commun et une quantité d'énergie restante de 1kWh.

Pour l'approche iso-distance selon l'art antérieur, cette quantité d'énergie restante correspond à une distance à parcourir de 5,5 km.

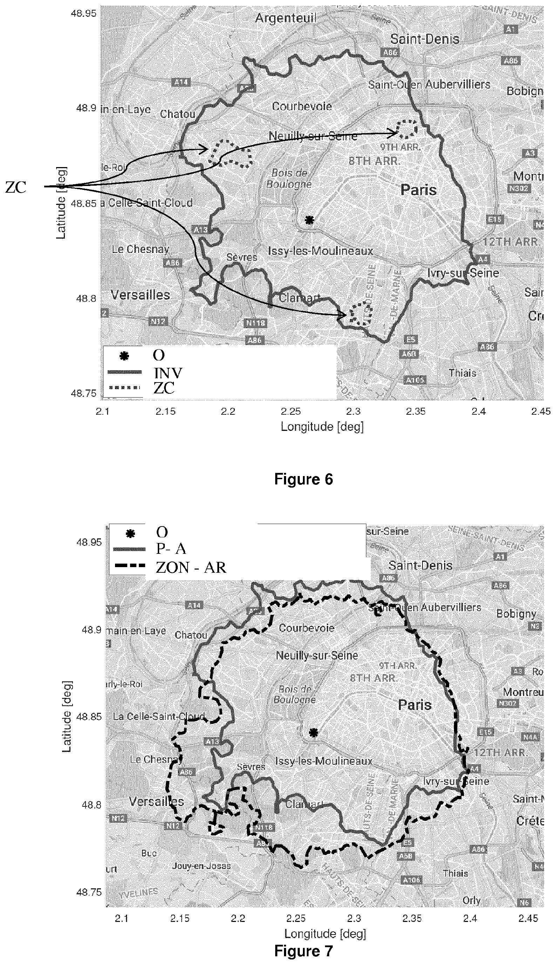

La figure 6 illustre, sur une carte de la région parisienne, les points atteignables depuis l'origine pour le procédé selon l'invention INV. On remarque que des zones critiques ZC ne sont pas atteignables par le véhicule. Il s'agit de points correspondant à des collines, pour lesquels une quantité supplémentaire d'énergie est nécessaire.

*Exemple 3*

Cet exemple 3 concerne une comparaison du procédé selon l'invention pour un trajet aller seul et pour un trajet aller-retour.

Pour cette comparaison, on estime un point de départ commun et une quantité d'énergie restante de 1kWh pour le trajet aller seul, et une quantité d'énergie restante de 2 kWh pour un trajet aller-retour.

La figure 7 illustre, sur une carte de la région parisienne, les points atteignables P-A pour un trajet aller seul depuis l'origine O, et les limites de la zone atteignable ZON-AR pour le trajet aller-retour depuis l'origine O.

On remarque que ces deux zones définies par les points P-A et ZON-AR ne sont pas identiques. Pour le cas d'un trajet aller-retour, la symétrie de la zone atteignable par rapport au point d'origine est accrue car les dépenses énergétiques élevées dans une direction (par exemple à cause d'un dénivelé positif) sont partiellement récupérées lors du trajet dans la direction opposée. Par ailleurs, les points non atteignables dans le cas d'un trajet d'aller simple deviennent admissibles si l'on considère le rayon d'action aller-retour.

*Exemple 4*

Cet exemple 4 présente les avantages en termes de mémoire du procédé selon l'invention.

En ce qui concerne la complexité de la structure de données et algorithmique, la modélisation sous forme de graphe adjoint, et l'utilisation d'une liste des arcs pour représenter ce graphe, présente des avantages.

En terme de complexité de la structure de données, pour un réseau routier donné de $n$ nœuds et $m$ arcs, une liste d'adjacence (par exemple telle que utilisée dans la demande de brevet US 2014/0278038 A1) représentant le graphe adjoint du réseau contient $V$ nœuds et $E$ arcs :

$$V = m$$

$$E = \sum_{i=1}^{n} ID(n_i) * OD(n_i)$$

Ou $n_i$ est le nœud $i$, $ID(n_i)$ est le nombre d'arcs entrants dans le nœud $i$, $OD(n_i)$ est le nombre d'arcs sortants du nœud $i$.

L'occupation en mémoire de cette structure de données est égale à $V+E$.

L'invention ici présentée, pour un réseau routier donné de $n$ nœuds et $m$ arcs, garde en mémoire une liste des arcs de dimension $E$ :

$$E = \sum_{i=1}^{n} ID(n_i) * OD(n_i)$$

L'occupation en mémoire de cette structure de données est égale à $E$, donc inférieur à celle de la structure de données de l'art antérieur.

En terme de complexité algorithmique, l'algorithme de chemin le plus court de Bellman-Ford a une complexité égale à $O(V * E)$ dans les deux cas. Avec la modification proposée dans l'invention, l'algorithme converge avec une complexité $O(k * E)$ ou $k \ll V$.

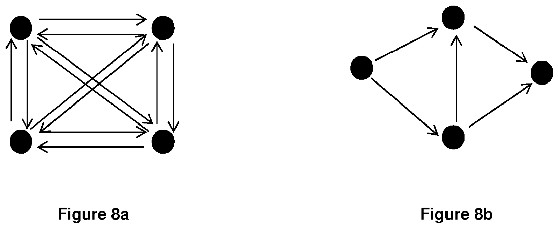

Pour mieux comprendre les différences, deux exemples de réseaux routiers sont représentés sur les figures 8a et 8b.

- Pour l'exemple de la figure 8a :
  On a un nombre de nœuds n égal à 4, et un nombre d'arcs m égal à n(n-1) = 12.

Le procédé selon l'invention gère une structure de données de taille $n(n-1)^2 = 36$, tandis que dans le cas d'une liste d'adjacence des arcs (art antérieur) la taille de la structure est de $n(n-1)+n(n-1)^2 = 48$.

Donc, l'algorithme de plus court chemin possède une complexité quadratique pour le procédé selon l'invention, au contraire, pour le procédé selon l'art antérieur, la complexité est d'ordre 3.

- Pour l'exemple de la figure 8b :
  On a un nombre de nœuds n égale à 4 et un nombre d'arcs égal à 5.

Le procédé selon l'invention gère une structure de taille 4, alors que la liste d'adjacence des arcs (de l'art antérieur) gère un nombre d'arcs égal à 9. Par conséquent, dans un cas où le nombre de manœuvres est comparable au nombre d'arcs du réseau routier, la complexité de la structure de données est double pour l'art antérieur, par rapport au procédé selon l'invention. Ainsi, l'invention nécessite des ressources matérielles (informatiques) moindres, notamment en termes de mémoire, et présente un temps de calcul réduit.

**Revendications**

1. Procédé de détermination d'au moins une zone (ZON) d'un réseau routier atteignable par un véhicule circulant au sein dudit réseau routier réalisant les étapes suivantes :

   a) on identifie la position (D) dudit véhicule et la quantité d'énergie stockée (Es) dans ledit véhicule ;
   b) on construit un modèle dynamique (MOD) dudit véhicule qui relie l'énergie consommée par ledit véhicule à la vitesse et à l'accélération dudit véhicule, ainsi qu'au profil de pente de la route ;
   c) on construit un graphe adjoint (GA) dudit réseau routier autour de ladite position (D) identifiée dudit véhicule en mettant en œuvre les étapes suivantes :

      i) on construit un graphe direct (GD) dudit réseau routier (RR) avec des nœuds (N) et des arcs (A), lesdits nœuds (N) dudit graphe direct (GD) correspondant aux intersections dudit réseau routier, et lesdits arcs (A) dudit graphe direct correspondant aux routes reliant lesdites intersections ; et
      ii) on construit ledit graphe adjoint (GA) dudit réseau routier (RR) avec des nœuds (N) et des arcs (A), lesdits nœuds (N) dudit graphe adjoint (GA) correspondant aux arcs (A) dudit graphe direct (GD) et lesdits arcs (A) dudit graphe adjoint (GA) correspondant à l'adjacence desdits arcs (A) dudit graphe direct (GD) ;

   d) on détermine l'énergie consommée par ledit véhicule pour chaque arc dudit graphe adjoint (GA) au moyen dudit modèle dynamique (MOD) du véhicule et d'une vitesse moyenne dudit véhicule sur ledit arc considéré, du profil de pente sur ledit arc considéré et d'une accélération dudit véhicule pour atteindre ladite vitesse moyenne sur ledit arc considéré ; et
   e) on détermine au moins une zone (ZON) dudit réseau routier atteignable par ledit véhicule avec ladite quantité d'énergie stockée (Es) dans ledit véhicule au moyen d'un algorithme de chemin le plus court (ALG) qui minimise sur ledit graphe adjoint (GA) ladite énergie consommée, ledit algorithme de chemin le plus court étant contraint par ladite quantité d'énergie stockée (Es) dans ledit véhicule.

2. Procédé selon la revendication 1, dans lequel on détermine ladite vitesse moyenne et ladite accélération dudit véhicule au moyen de conditions de trafic (TRA) et/ou de la topologie (TOP) et/ou des infrastructures dudit réseau routier.

3. Procédé selon la revendication 1, dans lequel on détermine ladite vitesse moyenne et ladite accélération dudit véhicule au moyen de conditions de trafic (TRA), lesdites conditions de trafic (TRA) étant obtenues en temps réel par communication avec des services de données en ligne.

4. Procédé selon la revendication 1, dans lequel on détermine ladite vitesse moyenne et ladite accélération dudit véhicule au moyen de conditions de trafic (TRA), lesdites conditions de trafic (TRA) étant stockées dans des moyens de stockage de données historiques.

5. Procédé selon la revendication 1, dans lequel on détermine ladite vitesse moyenne et ladite accélération dudit véhicule au moyen de la topologie (TOP) et on construit ledit graphe adjoint (GA) au moyen de la topologie (TOP) dudit réseau routier.

**6.** Procédé selon la revendication 1, dans lequel on détermine ladite vitesse moyenne et ladite accélération dudit véhicule au moyen de la topologie (TOP) et on détermine ladite topologie (TOP) dudit réseau routier (RR) par des moyens de géolocalisation.

**7.** Procédé selon l'une des revendications précédentes, dans lequel ledit modèle dynamique (MOD) du véhicule dépend de paramètres intrinsèques (PAR) dudit véhicule.

**8.** Procédé selon la revendication 7, dans lequel lesdits paramètres intrinsèques (PAR) dudit véhicule sont obtenus depuis une base de données, ou sont indiqués par un utilisateur.

**9.** Procédé selon l'une des revendications précédentes, dans lequel on affiche ladite zone (ZON) sur un dispositif autonome ou sur le tableau de bord dudit véhicule.

**10.** Procédé selon l'une des revendications précédentes, dans lequel ledit modèle dynamique (MOD) dudit véhicule dépend de la demande de puissance d'au moins un système auxiliaire dudit véhicule.

**11.** Procédé selon la revendication 10, dans lequel ladite demande de puissance d'au moins un système auxiliaire est fonction de la température extérieure.

**12.** Procédé selon l'une des revendications précédentes, dans lequel ledit algorithme de chemin le plus court (ALG) est un algorithme de Bellman-Ford.

**13.** Procédé selon l'une des revendications précédentes, dans lequel on détermine la consommation dudit véhicule pour au moins un point de ladite zone (ZON).

**14.** Procédé selon l'une des revendications précédentes, dans lequel ledit véhicule est un véhicule électrique, et la quantité d'énergie stockée dans le véhicule correspond à l'état de charge de la batterie dudit véhicule.

**15.** Produit programme d'ordinateur téléchargeable depuis un réseau de communication et/ou enregistré sur un support lisible par ordinateur et/ou exécutable par un processeur ou un serveur, comprenant des instructions de code de programme pour la mise en œuvre du procédé selon l'une des revendications précédentes, lorsque ledit programme est exécuté sur un ordinateur ou sur un téléphone portable.

**Patentansprüche**

**1.** Verfahren zur Bestimmung mindestens einer Zone (ZON) eines Straßennetzes, die von einem im Straßennetz fahrenden Fahrzeug erreicht werden kann, das die folgenden Schritte durchführt:

a) die Position (D) des Fahrzeugs und die im Fahrzeug gespeicherte Energiemenge (Es) werden identifiziert;
b) es wird ein dynamisches Modell (MOD) des Fahrzeugs konstruiert, das die vom Fahrzeug verbrauchte Energie mit der Geschwindigkeit und der Beschleunigung des Fahrzeugs sowie mit dem Neigungsprofil der Straße verbindet;
c) es wird ein Kantengraph (GA) des Straßennetzes um die identifizierte Position (D) des Fahrzeugs herum unter Anwendung der folgenden Schritte konstruiert:

i) ein gerichteter Graph (GD) des Straßennetzes (RR) wird mit Knoten (N) und Bögen (A) konstruiert, wobei die Knoten (N) des gerichteten Graphen (GD) den Kreuzungen des Straßennetzes entsprechen, und die Bögen (A) des gerichteten Graphen den die Kreuzungen verbindenden Straßen entsprechen; und
ii) der Kantengraph (GA) des Straßennetzes (RR) wird mit Knoten (N) und Bögen (A) konstruiert, wobei die Knoten (N) des Kantengraphen (GA) den Bögen (A) des gerichteten Graphen (GD) entsprechen und die Bögen (A) des Kantengraphen (GA) der Adjazenz der Bögen (A) des gerichteten Graphen (GD) entsprechen;

d) die vom Fahrzeug verbrauchte Energie wird für jeden Bogen des Kantengraphen (GA) mittels des dynamischen Modells (MOD) des Fahrzeugs und einer mittleren Geschwindigkeit des Fahrzeugs auf dem betreffenden Bogen, dem Neigungsprofil auf dem betreffenden Bogen und einer Beschleunigung des Fahrzeugs, um die mittlere Geschwindigkeit auf dem betreffenden Bogen zu erreichen, bestimmt; und

e) mindestens eine Zone (ZON) des Straßennetzes, die vom Fahrzeug mit der im Fahrzeug gespeicherten Energiemenge (Es) erreicht werden kann, wird mittels eines Algorithmus des kürzesten Wegs (ALG) bestimmt, der auf dem Kantengraph (GA) die verbrauchte Energie minimiert, wobei der Algorithmus des kürzesten Wegs von der im Fahrzeug gespeicherten Energiemenge (Es) eingeschränkt wird.

2.  Verfahren nach Anspruch 1, wobei die mittlere Geschwindigkeit und die Beschleunigung des Fahrzeugs mittels Verkehrsbedingungen (TRA) und/oder der Topologie (TOP) und/oder der Infrastrukturen des Straßennetzes bestimmt werden.

3.  Verfahren nach Anspruch 1, wobei die mittlere Geschwindigkeit und die Beschleunigung des Fahrzeugs mittels Verkehrsbedingungen (TRA) bestimmt werden, wobei die Verkehrsbedingungen (TRA) in Echtzeit durch Kommunikation mit Online-Datendiensten erhalten werden.

4.  Verfahren nach Anspruch 1, wobei die mittlere Geschwindigkeit und die Beschleunigung des Fahrzeugs mittels Verkehrsbedingungen (TRA) bestimmt werden, wobei die Verkehrsbedingungen (TRA) in Speichereinrichtungen historischer Daten gespeichert sind.

5.  Verfahren nach Anspruch 1, wobei die mittlere Geschwindigkeit und die Beschleunigung des Fahrzeugs mittels der Topologie (TOP) bestimmt werden, und der Kantengraph (GA) mittels der Topologie (TOP) des Straßennetzes konstruiert wird.

6.  Verfahren nach Anspruch 1, wobei die mittlere Geschwindigkeit und die Beschleunigung des Fahrzeugs mittels der Topologie (TOP) bestimmt werden, und die Topologie (TOP) des Straßennetzes (RR) durch Geolokalisierungseinrichtungen bestimmt wird.

7.  Verfahren nach einem der vorhergehenden Ansprüche, wobei das dynamische Modell (MOD) des Fahrzeugs von intrinsischen Parametern (PAR) des Fahrzeugs abhängt.

8.  Verfahren nach Anspruch 7, wobei die intrinsischen Parameter (PAR) des Fahrzeugs von einer Datenbank erhalten oder von einem Benutzer angegeben werden.

9.  Verfahren nach einem der vorhergehenden Ansprüche, wobei die Zone (ZON) auf einer autonomen Vorrichtung oder auf dem Armaturenbrett des Fahrzeugs angezeigt wird.

10. Verfahren nach einem der vorhergehenden Ansprüche, wobei das dynamische Modell (MOD) des Fahrzeugs von der Leistungsanforderung mindestens eines Hilfssystems des Fahrzeugs abhängt.

11. Verfahren nach Anspruch 10, wobei die Leistungsanforderung mindestens eines Hilfssystems von der Außentemperatur abhängt.

12. Verfahren nach einem der vorhergehenden Ansprüche, wobei der Algorithmus des kürzesten Wegs (ALG) ein Bellman-Ford-Algorithmus ist.

13. Verfahren nach einem der vorhergehenden Ansprüche, wobei der Verbrauch des Fahrzeugs für mindestens einen Punkt der Zone (ZON) bestimmt wird.

14. Verfahren nach einem der vorhergehenden Ansprüche, wobei das Fahrzeug ein Elektrofahrzeug ist, und die im Fahrzeug gespeicherte Energiemenge dem Ladezustand der Batterie des Fahrzeugs entspricht.

15. Computerprogrammprodukt, das von einem Kommunikationsnetz herunterladbar und/oder auf einem computerlesbaren Träger gespeichert und/oder von einem Prozessor oder einem Server ausführbar ist, das Programmcodeanweisungen zur Durchführung des Verfahrens nach einem der vorhergehenden Ansprüche enthält, wenn das Programm auf einem Computer oder einem Mobiltelefon ausgeführt wird.

**Claims**

1.  Method for determining at least one region (ZON) of a road network reachable by a vehicle being driven within said road network, carrying out the following steps:

a) the position (D) of said vehicle and the amount (Es) of energy stored in said vehicle are identified;

b) a dynamic model (MOD) of said vehicle, which relates the energy consumed by said vehicle to the speed and acceleration of said vehicle, and to the slope profile of the road, is constructed;

c) a line graph (GA) of said road network around said identified position (D) of said vehicle is constructed by implementing the following steps:

i) a direct graph (GD) of said road network (RR) is constructed with nodes (N) and arcs (A), said nodes (N) of said direct graph (GD) corresponding to the intersections of said road network, and said arcs (A) of said direct graph corresponding to the roads connecting said intersections; and

ii) said line graph (GA) is constructed from said road network (RR) with nodes (N) and arcs (A), said nodes (N) of said line graph (GA) corresponding to the arcs (A) of said direct graph (GD) and said arcs (A) of said line graph (GA) corresponding to the adjacency of said arcs (A) of said direct graph (GD);

d) the energy consumed by said vehicle for each arc of said line graph (GA) is determined by means of said dynamic model (MOD) of the vehicle and of an average speed of said vehicle on said arc in question, of the slope profile on said arc in question and of an acceleration of said vehicle to reach said average speed on said arc in question; and

e) at least one region (ZON) of said road network reachable by said vehicle with said amount (Es) of energy stored in said vehicle is determined by means of a shortest-path algorithm (ALG) that minimizes, on said line graph (GA), said energy consumed, said shortest-path algorithm being constrained by said amount (Es) of energy stored in said vehicle.

2. Method according to Claim 1, wherein said average speed and said acceleration of said vehicle are determined by means of traffic conditions (TRA) and/or of the topology (TOP) and/or of the infrastructure of said road network.

3. Method according to Claim 1, wherein said average speed and said acceleration of said vehicle are determined by means of traffic conditions (TRA), said traffic conditions (TRA) being obtained in real time via communication with web services.

4. Method according to Claim 1, wherein said average speed and said acceleration of said vehicle are determined by means of traffic conditions (TRA), said traffic conditions (TRA) being stored in means for storing historical data.

5. Method according to Claim 1, wherein said average speed and said acceleration of said vehicle are determined by means of the topology (TOP) and said line graph (GA) is constructed by means of the topology (TOP) of said road network.

6. Method according to Claim 1, wherein said average speed and said acceleration of said vehicle are determined by means of the topology (TOP) and said topology (TOP) of said road network (RR) is determined via geo-positioning means.

7. Method according to one of the preceding claims, wherein said dynamic model (MOD) of the vehicle depends on intrinsic parameters (PAR) of said vehicle.

8. Method according to Claim 7, wherein said intrinsic parameters (PAR) of said vehicle are obtained from a database, or are indicated by a user.

9. Method according to any one of the preceding claims, wherein said region (ZON) is displayed on a stand-alone device or on the dashboard of said vehicle.

10. Method according to one of the preceding claims, wherein said dynamic model (MOD) of said vehicle depends on the power demand of at least one auxiliary system of said vehicle.

11. Method according to Claim 10, wherein said power demand of at least one auxiliary system is dependent on outside temperature.

12. Method according to one of the preceding claims, wherein said shortest-path algorithm (ALG) is a Bellman-Ford algorithm.

13. Method according to one of the preceding claims, wherein the consumption of said vehicle is determined for at least one point of said region (ZON).

14. Method according to one of the preceding claims, wherein said vehicle is an electric vehicle, and the amount of energy stored in the vehicle corresponds to the state of charge of the battery of said vehicle.

15. Computer program product downloadable from a communication network and/or stored on a medium that is readable by computer and/or executable by a processor or a server, comprising program-code instructions for implementing the method according to one of the preceding claims, when said program is executed on a computer or on a mobile telephone.

**Figure 1**

**Figure 2**

RR        GD        GA

**Figure 3**

Figure 4

Figure 5

Figure 6

Figure 7

**Figure 8a**

**Figure 8b**

**EP 3 363 707 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015127204 A1
- US 2016129803 A1
- US 20140278038 A1
- WO 2014001565 A